# FASCICULE DE BREVET EUROPEEN

(11) **EP 3 790 126 B1**
(45) Date de publication et mention de la délivrance du brevet: **02.11.2022**
(21) Numéro de dépôt: 20193786.9
(22) Date de dépôt: 01.09.2020
(51) Int. Cl.: H01R 13/74, H01R 9/18, H05K 7/14, H01R 24/60

(54) **ENSEMBLE POUR CONNECTEURS ADAPTÉ À UN MONTAGE EN AVEUGLE**
EINHEIT FÜR STECKVERBINDER, DIE FÜR EINE BLINDMONTAGE GEEIGNET IST
ASSEMBLY FOR CONNECTORS ADAPTED FOR BLIND MOUNTING

(30) Priorité: 04.09.2019 FR 1909739
(43) Date de publication de la demande: 10.03.2021
(73) Titulaire: ALSTOM Transport Technologies, 93400 Saint-Ouen (FR)
(72) Inventeur: ZANETTI, Adrien, 69100 VILLEURBANNE (FR); BLANCHET, Damien, 01150 BLYES (FR)
(74) Mandataire: Lavoix

(56) Documents cités:
- EP-A1- 1 032 091
- WO-A1-2009/137822
- JP-A- 2001 244 029
- US-A1- 2010 248 536

## Description

La présente invention concerne un ensemble pour connecteurs, du type comportant : un panneau support, comportant : une première et une seconde faces opposées, et une ouverture de montage débouchant sur chacune desdites faces ; et un connecteur, comprenant une bride et un organe de montage, ledit organe de montage comprenant au moins un premier élément de montage ; ledit connecteur étant apte à être monté sur le panneau support dans une configuration assemblée, dans laquelle la bride est au contact de la première face du panneau et l'organe de montage est inséré dans l'ouverture de montage.

Un tel ensemble, connu par exemple du document US5514000, permet de réaliser un panneau de connexion supportant un ou plusieurs connecteurs électriques. Un tel panneau est par exemple intégré à un coffre de tiroir, apte à recevoir un tiroir électrique conforme à la norme EN 60297-3-101, comme décrit par exemple dans le document EP1732374 au nom de la Demanderesse.

Le document WO 2009/137822 A1 dévoile également le préambule de la revendication 1.

Il est fréquent que de tels panneaux ne soient accessibles à un opérateur que par une seule face, la face opposée étant trop encombrée. Il est donc intéressant de disposer d'un ensemble pour connecteurs permettant un montage et un démontage « en aveugle » sur le panneau, soit en intervenant sur une seule face dudit panneau.

A cet effet, l'invention a pour objet un ensemble selon la revendication 1.

Suivant d'autres aspects avantageux de l'invention, l'ensemble comporte les caractéristiques des revendications dépendantes, par exemple:
- l'organe de montage comprend en outre un second élément de montage, les premier et second éléments de montage étant disposés à deux extrémités opposées de la bride ; et l'ouverture de montage comporte en outre une portion principale et une portion de montage alignées avec les portions d'introduction et de blocage ; la portion principale étant configurée pour autoriser une introduction réversible du second élément de montage par translation perpendiculairement au panneau support ; la portion de montage étant configurée pour bloquer le second élément de montage par rapport au panneau en translation perpendiculairement au panneau support ;
- le dispositif de verrouillage comprend : une structure apte à être fixée à la seconde face du panneau support ; et une lame flexible par rapport à ladite structure, telle que dans la configuration assemblée, ladite lame s'étend en travers de la portion d'introduction de l'ouverture du panneau support ;
- le dispositif de verrouillage comprend en outre au moins une patte de connexion, telle que dans la configuration assemblée, ladite patte forme un contact électrique entre le panneau support et le premier élément de montage ;
- le dispositif de verrouillage comprend : une languette flexible, dont une extrémité est fixée à la bride du connecteur ; et un ergot formant saillie par rapport à ladite languette ; telle que dans la configuration assemblée, l'ergot forme une butée avec un bord de la portion d'introduction de l'ouverture ;
- le panneau support comprend une pluralité d'ouverture de montage, ledit ensemble comprenant en outre : une pluralité de connecteurs, chaque connecteur étant apte à être assemblé à l'une desdites ouvertures du panneau support dans la configuration assemblée ; et une pluralité de dispositifs de verrouillage, chacun desdits dispositifs étant associé à l'un desdits connecteurs.

L'invention se rapporte en outre à un panneau de connexion, réalisé à partir d'un ensemble tel que décrit ci-dessus, dans lequel le connecteur est monté sur le panneau support dans la configuration assemblée ; et le dispositif de verrouillage bloque un déplacement du premier élément de montage de la portion de blocage vers la portion d'introduction de l'ouverture.

L'invention se rapporte en outre à un procédé de montage de l'ensemble tel que décrit ci-dessus, comprenant les étapes suivantes : mise en contact de la bride du connecteur avec la première face du panneau support ; et introduction du premier élément de montage dans la portion d'introduction de l'ouverture ; de sorte à déformer élastiquement le dispositif de verrouillage depuis une position de repos ; puis déplacement du connecteur par rapport au panneau support, de sorte à introduire le premier élément de montage dans la portion de blocage de l'ouverture, le dispositif de verrouillage retrouvant ainsi la position de repos.

L'invention sera mieux comprise à la lecture de la description qui va suivre, donnée uniquement à titre d'exemple non limitatif et faite en se référant aux dessins sur lesquels :
- [Fig 1] [Fig 2] les figures 1 et 2 sont des vues en perspective d'un ensemble selon un mode de réalisation de l'invention, dans une configuration assemblée ; et
- [Fig 3] la figure 3 est une vue de détail d'un élément de l'ensemble des figures 1 et 2, dans une configuration dissociée.

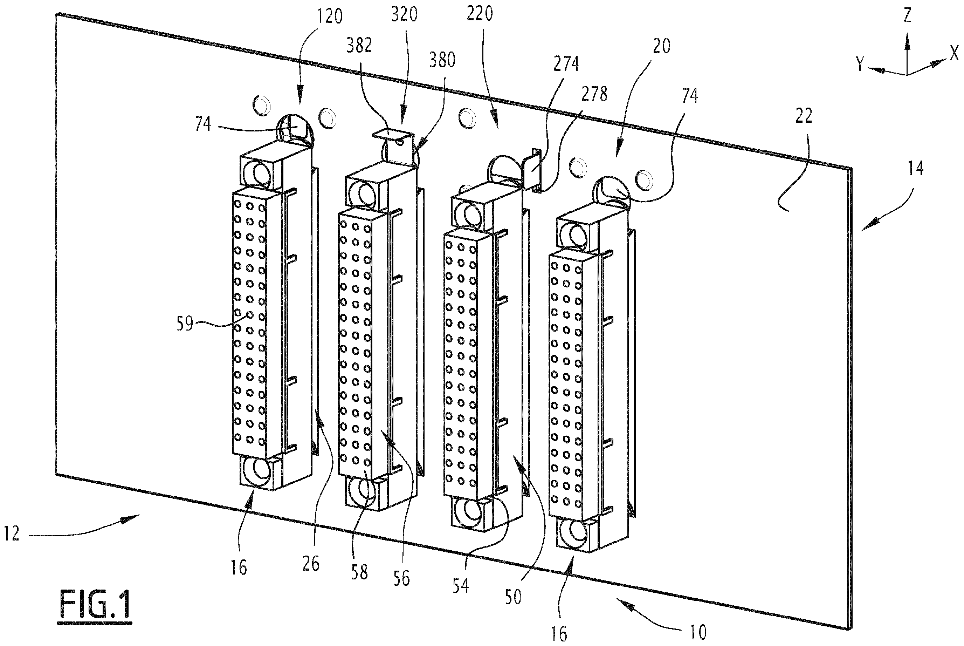

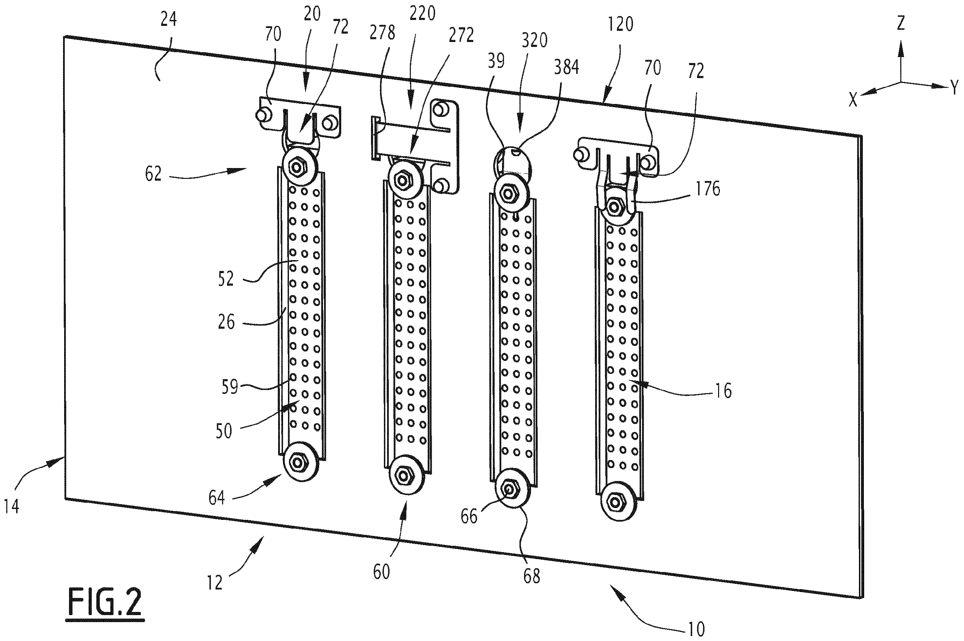

Les figures 1 et 2 montrent un ensemble 10 pour connecteurs selon un mode de réalisation de l'invention. Plus précisément, les figures 1 et 2 représentent l'ensemble 10 dans une configuration assemblée, sous forme d'un panneau 12 de connexion.

L'ensemble 10 comporte un panneau support 14, une pluralité de connecteurs 16 et une pluralité de dispositifs de verrouillage 20, 120, 220, 320.

Dans le mode de réalisation représenté, les dispositifs de verrouillage 20, 120, 220, 320 sont différents les uns des autres, de manière à illustrer différentes variantes de l'invention, comme il sera décrit par la suite.

De préférence, le panneau support 14 est réalisé dans un matériau électriquement conducteur, tel qu'un métal. En variante, le panneau support 14 est un PCB (printed card board).

Le panneau support 14 comporte une première 22 et une seconde 24 faces opposées, chacune desdites faces étant sensiblement plane. Dans la suite de la description, on considère une base orthonormée (X, Y, Z) associée au panneau support 14, chacune des première 22 et seconde 24 faces étant disposée dans un plan (Y, Z).

Les première 22 et seconde 24 faces sont essentiellement visibles, respectivement sur la figure 1 et sur la figure 2.

Le panneau support 14 comporte en outre une pluralité d'ouvertures 26 de montage, débouchant sur chacune des première 22 et seconde 24 faces. A titre indicatif, le nombre d'ouvertures 26 du panneau support 14, correspondant au nombre de connecteurs 16 de l'ensemble 10, est compris entre 1 et 21.

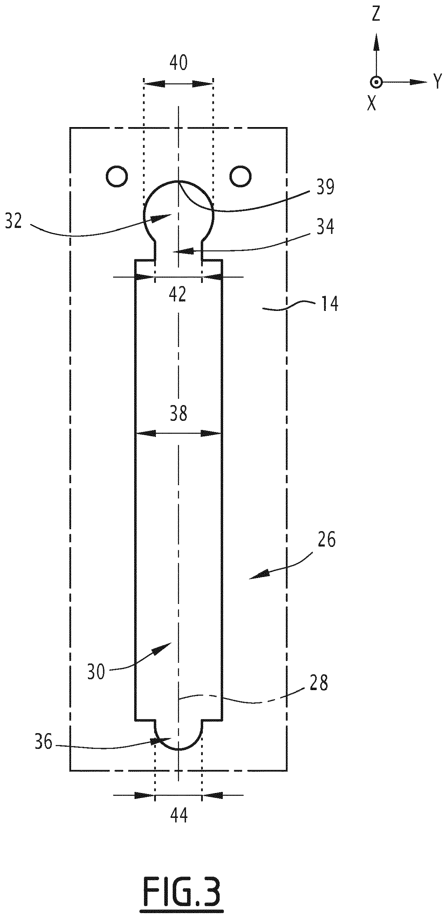

Dans le mode de réalisation représenté, les ouvertures 26 sont sensiblement identiques et alignées selon Y. Une ouverture 26 de montage du panneau support 14, représentée à la figure 3, est décrite ci-après.

L'ouverture 26 présente une forme allongée selon Z, ladite ouverture étant sensiblement symétrique par rapport à un axe 28 parallèle à Z.

L'ouverture 26 comporte : une portion principale 30 ; une portion d'introduction 32 ; une portion de blocage 34 et une portion de montage 36. Lesdites portions 30, 32, 34, 36 sont alignées selon Z, dans un ordre précisé ci-après, et ouvertes les unes sur les autres.

La portion principale 30 présente une forme sensiblement rectangulaire allongée. Une dimension selon Z de ladite portion principale 30 représente au moins 50% et préférentiellement au moins 75% d'une dimension totale selon Z de l'ouverture 26. La portion principale 30 présente une première dimension selon Y, dite première dimension transversale 38, sensiblement constante.

La portion d'introduction 32 forme une première extrémité selon Z de l'ouverture 26. La portion d'introduction 32 est définie par un bord 39 et présente une deuxième dimension maximale selon Y, dite deuxième dimension transversale 40. Dans le mode de réalisation représenté, le bord 39 a une forme sensiblement circulaire.

La portion de blocage 34 est disposée entre la portion principale 30 et la portion d'introduction 32. Selon Y, la portion de blocage 34 présente une troisième dimension transversale 42, inférieure aux première 38 et deuxième 40 dimensions transversales. En d'autres termes, la portion de blocage 34 forme un rétrécissement entre la portion principale 30 et la portion d'introduction 32.

La portion de montage 36, adjacente à la portion principale 30, forme une seconde extrémité selon Z de l'ouverture 26 à l'opposé de la portion d'introduction. La portion de montage 36 présente une quatrième dimension transversale 44 maximale, inférieure à la première dimension transversale 38.

Les connecteurs 16 de l'ensemble 10 selon le mode de réalisation représenté sont sensiblement identiques et correspondent à la description ci-après. Les repères selon (X, Y, Z) s'entendent dans la configuration assemblée du panneau 12 de connexion.

Le connecteur 16 comporte une bride 50 de montage, de préférence réalisée dans un matériau électriquement isolant tel que du plastique. Ladite bride comprend une première 52 et une deuxième 54 surfaces opposées, sensiblement planes. Chacune des première 52 et deuxième 54 surfaces est située dans un plan (Y, Z) et présente une forme allongée selon Z.

Le connecteur 16 comporte en outre une portion de couplage 56, formant saillie par rapport à la deuxième surface 54. La portion de couplage 56 comprend par exemple des broches (non représentées) de connexion à un connecteur complémentaire (non représenté). Sur la figure 1, lesdites broches sont recouvertes par un capot 58.

Par ailleurs, la première surface 52 comporte des moyens d'assemblage avec des connexions ou contacts électriques, de sorte à relier électriquement la portion de couplage 56 avec un élément extérieur. Ce couplage électrique est par exemple réalisé par des fils, des câbles ou des flexibles.

En particulier, dans le mode de réalisation représenté, la bride 50 et le capot 58 présentent des orifices 59 de connexion, permettant le passage de tels fils, câbles ou flexibles.

Le connecteur 16 comporte en outre un organe de montage 60 pour être assemblé au panneau support 14. Dans le mode de réalisation représenté, l'organe de montage 60 comporte un premier 62 et un second 64 éléments de montage. Chacun desdits éléments 62, 64 est disposé à une extrémité selon Z de la première surface 52 de la bride 50.

Comme décrit ci-après, le premier élément de montage 62 présente une forme apte à être introduite de manière réversible selon X dans la portion d'introduction 32 d'une ouverture 26 du panneau support 14. Par ailleurs, ladite forme est apte à être bloquée en translation selon X dans la portion de blocage 34 de ladite ouverture.

Par ailleurs, le second élément de montage 64 présente une forme apte à être introduite de manière réversible selon X dans la portion principale 30 de ladite ouverture 26. Ladite forme est en outre apte à être bloquée en translation selon X dans la portion de montage 36 de ladite ouverture.

De préférence, comme décrit ci-après, au moins le premier élément de montage 62 est réalisé dans un matériau électriquement bon conducteur, tel qu'un métal. Avantageusement, l'élément de montage 62 est en laiton nickelé.

Dans le mode de réalisation représenté, les premier 62 et second 64 éléments de montage sont sensiblement identiques et correspondent à la description ci-après. L'élément de montage 62, 64 comporte : une tige 66 formant saillie selon X par rapport à la première surface 52 ; et une rondelle 68 disposée à une extrémité de la tige, opposée à ladite première surface. Un espace (non représenté) est ainsi ménagé selon X entre ladite rondelle 68 et la bride 50.

La rondelle 68 présente un contour circulaire, de forme sensiblement complémentaire à celle du bord 39 de la portion d'introduction 32. Un diamètre de ladite rondelle 68 est strictement supérieur aux troisième 42 et quatrième 44 dimensions transversales des portions de blocage 34 et de montage 36. De préférence, ledit diamètre est strictement inférieur aux première 38 et deuxième 40 dimensions transversales des portions principale 30 et d'introduction 32.

Par ailleurs, la tige 66 présente une section de diamètre inférieur aux troisième 42 et quatrième 44 dimensions transversales.

Dans la configuration assemblée du panneau 12 de connexion, la première surface 52 de la bride 50 du connecteur 16 est essentiellement en vis-à-vis de la portion principale 30 de l'ouverture 26 correspondante. Les connexions électriques (non représentée) portées par ladite première surface 52 peuvent ainsi traverser ladite portion principale 30.

En outre, dans ladite configuration assemblée, chaque extrémité selon Z de la première surface 52 est au contact de la première face 22 du panneau support 14. La tige 66 de chacun des premier 62 et second 64 éléments de montage est disposée, respectivement, dans la portion de blocage 34 et dans la portion de montage 36 de l'ouverture. Au niveau de chacun desdits premier 62 et second 64 éléments de montage, le bord de l'ouverture 26 est ainsi pris en sandwich entre la rondelle 68 correspondante et la première surface 52 de la bride 50. Le connecteur 16 est donc bloqué en translation selon X par rapport au panneau support 14.

Selon un mode de réalisation préféré, des jeux selon Y et Z sont prévus entre chaque tige 66 et, respectivement, la portion de blocage 34 et la portion de montage 36. De manière connue, le connecteur 16 possède ainsi un degré de liberté selon Y et Z par rapport au panneau support 14, ce qui correspond à un montage dit « avec flottement » dudit connecteur 16.

Dans le panneau 12 de connexion, chaque dispositif de verrouillage 20, 120, 220, 320 est associé à une ouverture 26 distincte du panneau support 14, ainsi qu'à un connecteur 16 distinct, de sorte à bloquer ledit connecteur 16 dans ladite ouverture 26 comme décrit ci-après. Les dispositifs de verrouillage 20, 120, 220, 320 seront décrits simultanément ci-après, les éléments communs étant désignés par les mêmes numéros de référence.

Le dispositif de verrouillage 20, 120, 220, 320 est apte à se déformer élastiquement sous l'effet d'un déplacement du premier élément de montage 62 dans l'ouverture 26, de la portion d'introduction 32 vers la portion de blocage 34. En outre, ledit dispositif de verrouillage 20, 120, 220, 320 est apte à bloquer un déplacement opposé dudit premier élément de montage 62 dans l'ouverture 26, soit de la portion de blocage 34 vers la portion d'introduction 32.

Chacun des premier 20, deuxième 120 et troisième 220 dispositifs de verrouillage comporte : une structure 70 fixée à la seconde 24 face du panneau support 14 ; et une lame 72, 272 flexible par rapport à la structure 70. La lame 72, 272 s'étend en travers de la portion d'introduction 32 de l'ouverture 26 associée.

De préférence, la structure 70 et la lame 72, 272 sont réalisées dans un matériau électriquement bon conducteur, tel qu'un métal, et ayant aussi une résistance vie élastique importante, notamment pour le deuxième dispositif de verrouillage 120.

Dans chacun des premier 20 et deuxième 120 dispositifs de verrouillage, la lame 72 s'étend sensiblement selon Z en position de repos. Une extrémité 74 de ladite lame 72 est disposée en vis-à-vis de la portion d'introduction 32, à proximité de la portion de blocage 34.

Le deuxième dispositif de verrouillage 120 comporte en outre deux pattes de connexion 176, flexibles par rapport à la structure 70 et disposées de part et d'autre de la lame 72. Les pattes de connexion 176 sont métalliques et formées d'une pièce avec la structure 70.

Dans la configuration assemblée du panneau 12 de connexion, les pattes de connexion 176 du deuxième dispositif de verrouillage 120 sont au contact de la rondelle 68 du premier élément de montage 62. Ce mode de réalisation permet de créer un contact électrique entre le connecteur 16 correspondant et le panneau support 14, afin par exemple de relier ledit connecteur 16 à la masse.

Dans le troisième dispositif de verrouillage 220, la lame 272 s'étend sensiblement selon Y et présente une extrémité 274 en forme de crochet. Ledit troisième dispositif de verrouillage 220 comporte en outre une fente 278 ménagée dans le panneau support 14 à l'opposé de la structure 70 par rapport à la portion d'introduction 32. En position de repos de la lame 272, l'extrémité 274 est insérée dans la fente 278 et fait saillie du côté de la première face 22 du panneau support.

Le quatrième dispositif de verrouillage 320 comporte une languette 380 flexible, dont une extrémité est fixée à la première surface 52 de la bride 50 du connecteur 16 associé. La languette 380 forme saillie selon Z par rapport à ladite bride, du côté du premier élément de montage 62. Le repère s'entend dans la configuration assemblée du panneau 12 de connexion.

Une autre extrémité 382 de ladite languette, opposée à la bride 50, présente une forme de crochet orienté selon X vers la deuxième surface 54.

Le quatrième dispositif de verrouillage 320 comporte en outre un ergot 384 faisant saillie par rapport à la languette 380 du côté opposé au crochet de l'extrémité 382. L'ergot 384 est par exemple réalisé par un poinçonnement dans la languette 380.

Selon une variante au mode de réalisation représenté de l'ensemble 10 et du panneau de connexion 12, chaque connecteur 16 et chaque ouverture 26 correspondante du panneau support 14 sont associés à un dispositif de verrouillage identique, par exemple choisi parmi les dispositifs 20, 120, 220, 320 décrits ci-dessus.

Un procédé de montage de l'ensemble 10 ci-dessus, de sorte à réaliser le panneau de connexion 12 ci-dessus, va maintenant être décrit.

Tout d'abord, la structure 70 de chacun des premier 20, deuxième 120 et troisième 220 dispositifs de verrouillage est fixée à la seconde 24 face du panneau support 14, à proximité de la portion d'introduction 32 de l'ouverture 26 associée. En outre, la languette 380 du quatrième dispositif de verrouillage 320 est assemblée au connecteur 16 associé.

Ensuite, chaque connecteur 16 est disposé en vis-à-vis de l'ouverture 26 correspondante, la première surface 52 de la bride 50 faisant face à la première face 22 du panneau support 14.

Par translation selon X, les premiers 62 et second 64 éléments de montage sont introduits respectivement dans la portion d'introduction 32 et dans la portion principale 30 de l'ouverture 26. La lame 72, 272 ou la languette 380 du dispositif de verrouillage 20, 120, 220, 320 correspondant subit une flexion élastique pour autoriser cette introduction.

La première surface 52 de la bride 50 étant au contact du panneau support 14, le connecteur 16 est ensuite déplacé selon Z par rapport au panneau support 14, de sorte à introduire les tiges 66 des premiers 62 et second 64 éléments de montage, respectivement dans la portion de blocage 34 et dans la portion de montage 36 de l'ouverture 26. La rondelle 68 de chaque élément de montage 62, 64 vient ainsi s'engager du côté de la seconde face 24 du panneau support 14.

Pour les premier 20, deuxième 120 et troisième 220 dispositifs de verrouillage, le déplacement ci-dessus du connecteur 16 éloigne la lame 72, 272 du premier élément de montage 62. Ladite lame retrouve donc sa position de repos, en travers de la portion d'introduction 32. Ledit premier élément de montage 62 est donc empêché par ladite lame 72, 272 de se déplacer vers ladite portion d'introduction.

Pour le quatrième dispositif de verrouillage, le déplacement ci-dessus du connecteur 16 conduit à l'engagement de l'ergot 384 dans la portion d'introduction 32. La butée formée entre ledit ergot et le bord 39 de ladite portion d'introduction empêche le premier élément de montage 62 de se déplacer vers ladite portion d'introduction.

Chaque dispositif de verrouillage 20, 120, 220, 320 bloque donc le connecteur 16 associé dans la configuration assemblée décrite ci-dessus.

Le procédé décrit ci-dessus permet un montage dit « en aveugle », soit uniquement à partir de la première face 22 du panneau support 14. Ce type de montage est particulièrement avantageux lorsque la seconde face 24 dudit panneau est peu accessible. De plus, ce type de montage facilite le dépannage au niveau du connecteur avec un accès rapide vers les connexions extérieures selon la première face 22 uniquement.

Chaque dispositif de verrouillage 20, 120, 220, 320 ci-dessus permet un déverrouillage de l'ensemble, afin de démonter les connecteurs.

Pour les premier 20 et deuxième 120 dispositifs, le déverrouillage est obtenu en appuyant sur l'extrémité 74 de la lame 72 à travers la portion d'introduction 32 de l'ouverture 26 associée, par exemple au moyen d'un tournevis.

Pour le troisième dispositif 220, le déverrouillage est obtenu en poussant l'extrémité 274 de la lame 272 depuis la première face 22 du panneau support 14, ce qui conduit à la déformation de ladite lame. Pour le quatrième dispositif 320, la languette 380 est déformée de manière similaire par traction sur son extrémité 382.

## Revendications

1. Ensemble (10) pour connecteurs, comprenant :
- un panneau support (14), comportant : une première (22) et une seconde (24) faces opposées ; et une ouverture (26) de montage débouchant sur chacune desdites faces ; et
- un connecteur (16), comprenant une bride (50) et un organe (60) de montage, ledit organe de montage comprenant au moins un premier élément de montage (62) ; ledit connecteur étant apte à être monté sur le panneau support dans une configuration assemblée, dans laquelle la bride est au contact de la première face (22) du panneau et le premier élément de montage est inséré dans l'ouverture de montage ;
dans lequel
- l'ouverture de montage comporte une portion d'introduction (32) et une portion de blocage (34), alignées selon une direction (Z) parallèle au panneau support, la portion de blocage recevant le premier élément de montage (62) en configuration assemblée ;
la portion d'introduction (32) étant configurée pour autoriser une introduction réversible du premier élément de montage (62) par translation perpendiculairement (X) au panneau support ; ladite portion d'introduction étant définie par un bord (39) de forme sensiblement circulaire ;
la portion de blocage (34) étant configurée pour bloquer le premier élément de montage par rapport au panneau en translation perpendiculairement au panneau support, ladite portion de blocage (34) présentant une dimension (42) inférieure à la dimension transversale (40) de la portior d'introduction (32) perpendiculairement à la direction (Z) d'alignement desdites portions ; et
- l'ensemble comprend en outre un dispositif de verrouillage (20, 120, 220, 320), ledit dispositif étant apte à se déformer élastiquement sous l'effet d'ur déplacement du premier élément de montage (62) de la portion d'introduction vers la portion de blocage ; et à bloquer un déplacement opposé dudit premier élément de montage,
l'ensemble étant **caractérisé en ce que**:
le premier élément de montage (62) comprenant une tige (66) formant saillie par rapport à la première surface (52) de la bride (50) et une rondelle (68) disposée à une extrémité de la tige, opposée à ladite première surface, un espace étant ménagé entre ladite rondelle (68) et la bride (50), la rondelle (68) présentant un contour circulaire, de forme sensiblement complémentaire à celle du bord (39) de la portion d'introduction (32).

2. Ensemble selon la revendication 1, dans lequel le premier élément de montage (62) est réalisé dans un métal électriquement bon conducteur.

3. Ensemble selon la revendication 2, dans lequel le premier élément de montage (62) est réalisé en laiton nickelé.

4. Ensemble selon l'une des revendications 1 à 3, dans lequel :
- l'organe de montage comprend en outre un second (64) élément de montage, les premier et second éléments de montage étant disposés à deux extrémités opposées de la bride (50) ; et
- l'ouverture de montage (26) comporte en outre une portion principale (30) et une portion de montage (36) alignées avec les portions d'introduction et de blocage, la portion de montage recevant le second élément de montage (64) en configuration assemblée ;
la portion principale (30) étant configurée pour autoriser une introduction réversible du second élément de montage (64) par translation perpendiculairement (X) au panneau support ;
la portion de montage étant configurée pour bloquer le second élément de montage par rapport au panneau en translation perpendiculairement au panneau support.

5. Ensemble selon la revendication 4, dans lequel un diamètre de la rondelle (68) est strictement supérieur à des dimensions transversales (42, 44) des portions de blocage (34) et de montage (36).

6. Ensemble selon la revendication 5, dans lequel le diamètre de la rondelle (68) est strictement inférieur à des dimensions transversales (38, 40) des portions principale (30) et d'introduction (32).

7. Ensemble selon l'une des revendications précédentes, dans lequel le dispositif de verrouillage (20, 120, 220) comprend : une structure (70) apte à être fixée à la seconde face (24) du panneau support (14) ; et une lame (72, 272) flexible par rapport à ladite structure, telle que dans la configuration assemblée, ladite lame obstrue, au moins partiellement, la portion d'introduction (32) de l'ouverture (26) du panneau support.

8. Ensemble selon la revendication 7, dans lequel le dispositif de verrouillage (120) comprend en outre au moins une patte (176) de connexion, telle que dans la configuration assemblée, ladite patte forme un contact électrique entre le panneau support (14) et le premier élément de montage (62).

9. Ensemble selon l'une des revendications 1 à 4, dans lequel le dispositif de verrouillage (320) comprend : une languette (380) flexible, dont une extrémité est fixée à la bride (50) du connecteur (16) ; et un ergot (384) formant saillie par rapport à ladite languette ; telle que dans la configuration assemblée, l'ergot forme une butée avec le bord (39) de la portion d'introduction (32) de l'ouverture (26).

10. Ensemble selon l'une quelconque des revendications précédentes, dans lequel le panneau support comprend une pluralité d'ouverture (26) de montage,
ledit ensemble comprenant en outre : une pluralité de connecteurs (16), chaque connecteur étant apte à être assemblé à l'une desdites ouvertures (26) du panneau support dans la configuration assemblée ; et une pluralité de dispositifs de verrouillage (20, 120, 220, 320), chacun desdits dispositifs étant associé à l'un desdits connecteurs.

11. Panneau (12) de connexion, réalisé à partir d'un ensemble (10) selon l'une quelconque des revendications précédentes, ledit panneau de connexion comprenant le panneau support (14), le connecteur (16) et le dispositif de verrouillage (20, 120, 220, 320), dans lequel :le connecteur (16) est monté sur le panneau support (14) dans la configuration assemblée ; et le dispositif de verrouillage bloque un déplacement du premier élément de montage (62) de la portion de blocage (34) vers la portion d'introduction (32) de l'ouverture (26).

12. Procédé de montage de l'ensemble (10) selon l'une quelconque des revendications 1 à 10, comprenant les étapes suivantes :
- mise en contact de la bride (50) du connecteur (16) avec la première face (22) du panneau support (14) ; et introduction du premier élément de montage (62) dans la portion d'introduction (32) de l'ouverture (26) ; de sorte à déformer élastiquement le dispositif de verrouillage (20, 120, 220, 320) depuis une position de repos ; puis
- déplacement du connecteur (16) par rapport au panneau support, de sorte à introduire le premier élément de montage (62) dans la portion de blocage de l'ouverture, le dispositif de verrouillage retrouvant ainsi la position de repos.

## Patentansprüche

1. Anordnung (10) für Verbinder, umfassend:
- Trägerplatte (14), umfassend: eine erste (22) und eine zweite (24) gegenüberliegende Seite; und eine Montageöffnung (26), die in jede der Seiten mündet; und
- einen Verbinder (16), umfassend einen Flansch (50) und ein Montageelement (60), das Montageelement umfassend mindestens ein erstes Montageelement (62); wobei der Verbinder geeignet ist, um an der Trägerplatte in einer zusammengefügten Konfiguration montiert zu werden, in der der Flansch die erste Seite (22) der Platte berührt und das erste Montageelement in die Montageöffnung eingeführt ist; wobei
- die Montageöffnung einen Einführungsabschnitt (32) und einen Arretierabschnitt (34) umfasst, die in einer Richtung (Z) parallel zu der Trägerplatte ausgerichtet sind, wobei der Arretierabschnitt das erste Montageelement (62) in zusammengefügter Konfiguration aufnimmt;
wobei der Einführungsabschnitt (32) konfiguriert ist, um ein reversibles Einführen des ersten Montageelements (62) durch Translation senkrecht (X) zu der Trägerplatte zu ermöglichen; wobei der Einführungsabschnitt durch einen Rand (39) mit im Wesentlichen kreisförmiger Form definiert ist;
der Arretierabschnitt (34) konfiguriert ist, um das erste Montageelement bei der Translation senkrecht zu der Trägerplatte in Bezug auf die Platte zu arretieren, wobei der Arretierabschnitt (34) eine Abmessung aufweist, die kleiner ist als die Querabmessung (40) des Einführungsabschnitts (32) senkrecht zu der Richtung (Z) einer Ausrichtung der Abschnitte; und
- die Anordnung ferner eine Verriegelungsvorrichtung (20, 120, 220, 320) umfasst, wobei die Vorrichtung geeignet ist, um sich bei einer Verlagerung des ersten Montageelements (62) von dem Einführungsabschnitt zu dem Arretierabschnitt elastisch zu verformen; und eine entgegengesetzte Verlagerung des ersten Montageelements zu arretieren, wobei die Anordnung **dadurch gekennzeichnet ist, dass**:
das erste Montageelement (62) einen Schaft (66), der von der ersten Oberfläche (52) des Flanschs (50) hervorsteht, und eine Unterlegscheibe (68), die an einem Ende des Schafts gegenüber der ersten Oberfläche angeordnet ist, umfasst, wobei zwischen der Unterlegscheibe (68) und dem Flansch (50) ein Zwischenraum ausgebildet ist, wobei die Unterlegscheibe (68) eine kreisförmige Kontur aufweist, deren Form im Wesentlichen komplementär zu der des Rands (39) des Einführungsabschnitts (32) ist.

2. Anordnung nach Anspruch 1, wobei das erste Montageelement (62) aus einem elektrisch gut leitenden Metall hergestellt ist.

3. Anordnung nach Anspruch 2, wobei das erste Montageelement (62) aus vernickeltem Messing hergestellt ist.

4. Anordnung nach einem der Ansprüche 1 bis 3, wobei:
- das Montageelement ferner ein zweites (64) Montageelement umfasst, wobei das erste und das zweite Montageelement an zwei gegenüberliegenden Enden des Flansches (50) angeordnet sind; und
- die Montageöffnung (26) ferner einen Hauptabschnitt (30) und einen Montageabschnitt (36) aufweist, die mit dem Einführungs- und Arretierabschnitt ausgerichtet sind, wobei der Montageabschnitt das zweite Montageelement (64) in zusammengefügter Konfiguration aufnimmt;
wobei der Hauptabschnitt (30) konfiguriert ist, um ein reversibles Einführen des zweiten Montageelements (64) durch Translation senkrecht (X) zu der Trägerplatte zuzulassen;
wobei der Montageabschnitt konfiguriert ist, um das zweite Montageelement in Bezug auf die Platte gegen eine Translation senkrecht zu der Trägerplatte zu arretieren.

5. Anordnung nach Anspruch 4, wobei ein Durchmesser der Unterlegscheibe (68) strikt größer ist als Querabmessungen (42, 44) des Arretierabschnitts (34) und des Montageabschnitts (36).

6. Anordnung nach Anspruch 5, wobei der Durchmesser der Unterlegscheibe (68) strikt kleiner ist als Querabmessungen (38, 40) des Hauptabschnitts (30) und Einführungsabschnitts (32).

7. Anordnung nach einem der vorherigen Ansprüche, wobei die Verriegelungsvorrichtung (20, 120, 220) Folgendes umfasst: eine Struktur (70), die geeignet ist, um an der zweiten Seite (24) der Trägerplatte (14) befestigt zu werden; und eine Lamelle (72, 272), die in Bezug auf die Struktur flexibel ist, sodass die Klinge in der zusammengefügten Konfiguration mindestens teilweise den Einführungsabschnitt (32) der Öffnung (26) der Trägerplatte verschließt.

8. Anordnung nach Anspruch 7, wobei die Verriegelungsvorrichtung (120) ferner mindestens eine Verbindungslasche (176) umfasst, sodass die Lasche in der zusammengefügten Konfiguration einen elektrischen Kontakt zwischen der Trägerplatte (14) und dem ersten Montageelement (62) bildet.

9. Anordnung nach einem der Ansprüche 1 bis 4, wobei die Verriegelungsvorrichtung (320) Folgendes umfasst: eine flexible Zunge (380), wovon ein Ende an dem Flansch (50) des Verbinders (16) befestigt ist; und einen Vorsprung (384), der von der Zunge hervorsteht; sodass der Vorsprung in der zusammengefügten Konfiguration einen Anschlag mit dem Rand (39) des Einführungsabschnitts (32) der Öffnung (26) bildet.

10. Anordnung nach einem der vorherigen Ansprüche, wobei die Trägerplatte eine Vielzahl von Montageöffnungen (26) umfasst, wobei die Anordnung ferner Folgendes umfasst: eine Vielzahl von Verbindern (16), wobei jeder Verbinder in der zusammengefügten Konfiguration mit einer der Öffnungen (26) der Trägerplatte zusammengefügt werden kann; und eine Vielzahl von Verriegelungsvorrichtungen (20, 120, 220, 320), wobei jede der Vorrichtungen mit einem der Verbinder assoziiert ist.

11. Verbindungsplatte (12), die aus einer Anordnung (10) nach einem der vorherigen Ansprüche hergestellt ist, die Verbindungsplatte umfassend die Trägerplatte (14), den Verbinder (16) und die Verriegelungsvorrichtung (20, 120, 220, 320), wobei: der Verbinder (16) in der zusammengefügten Konfiguration an der Trägerplatte (14) montiert ist; und die Verriegelungsvorrichtung eine Verlagerung des ersten Montageelements (62) von dem Arretierabschnitt (34) zu dem Einführungsabschnitt (32) der Öffnung (26) arretiert.

12. Herstellungsverfahren der Anordnung (10) nach einem der Ansprüche 1 bis 10, umfassend die folgenden Schritte:
- Inkontaktbringen des Flanschs (50) des Verbinders (16) mit der ersten Seite (22) der Trägerplatte (14); und Einführen des ersten Montageelements (62) in den Einführungsabschnitt (32) der Öffnung (26); sodass die Verriegelungsvorrichtung (20, 120, 220, 320) aus einer Ruheposition elastisch verformt wird; und dann
- Verschieben des Verbinders (16) in Bezug auf die Trägerplatte, um das erste Montageelement (62) in den Arretierabschnitt der Öffnung einzuführen, wodurch die Verriegelungsvorrichtung in die Ruhestellung zurückkehrt.

## Claims

1. A connector assembly (10), comprising:
- a support panel (14) comprising: first (22) and second (24) opposing faces; and a mounting aperture (26) opening into each of said surfaces; and
- a connector (16), comprising a flange (50) and a mounting member (60), said mounting member comprising at least a first mounting element (62); said connector being adapted to be mounted to the support panel in an assembled configuration, wherein the flange contacts the first face (22) of the panel and the first mounting element is inserted into the mounting aperture;
wherein
- the mounting aperture comprises an insertion portion (32) and a blocking portion (34), aligned in a direction (Z) parallel to the support panel, the locking portion receiving the first mounting element (62) in an assembled configuration;
the insertion portion (32) being configured to allow reversible insertion of the first mounting element (62) by translation perpendicularly (X) to the support panel; said insertion portion being defined by an edge (39) of substantially circular shape;
the blocking portion (34) being configured to lock the first mounting member relative to the panel in translation perpendicular to the support panel, said blocking portion (34) having a dimension less than the transverse dimension (40) of the insertion portion (32) perpendicular to the direction (Z) of alignment of said portions; and
- the assembly further comprises a locking device (20, 120, 220, 320), said device being capable of elastically deforming under the effect of a movement of the first mounting member (62) from the insertion portion to the blocking portion; and of blocking an opposite movement of said first mounting member, the assembly being **characterised in that**:
the first mounting member (62) comprising a shank (66) projecting from a first surface (52) of the flange (50) and a washer (68) disposed at an end of the shank opposite said first surface, a space being provided between said washer (68) and the flange (50), the washer (68) having a circular outline substantially complementary in shape to the edge (39) of the insertion portion (32).

2. The assembly according to claim 1, wherein the first mounting member (62) is made of a metal good at conducting electricity.

3. The assembly according to claim 2, wherein the first mounting member (62) is made of nickel-plated brass.

4. The assembly according to one of claims 1 to 3, wherein:
- the mounting member further comprises a second mounting element (64), the first and second mounting elements being disposed at two opposite ends of the flange (50); and
- the mounting aperture (26) further comprises a main portion (30) and a mounting portion (36) aligned with the insertion and locking portions, the mounting portion receiving the second mounting member (64) in an assembled configuration;
the main portion (30) being configured to allow reversible insertion of the second mounting element (64) by translation perpendicularly (X) to the support panel;
the mounting portion being configured to lock the second mounting member relative to the panel in translation perpendicular to the support panel.

5. The assembly according to claim 4, wherein a diameter of the washer (68) is strictly greater than transverse dimensions (42, 44) of the locking (34) and mounting (36) portions.

6. The assembly according to claim 5, wherein a diameter of the washer (68) is strictly less than transverse dimensions (38, 40) of the main (30) and insertion (32) portions.

7. The assembly according to one of the preceding claims, wherein the locking device (20, 120, 220) comprises: A structure (70) adapted to be fixed to the second face (24) of the support panel (14); and a blade (72, 272) flexible with respect to said structure, such that in the assembled configuration said blade obstructs, at least partially, the insertion portion (32) of the aperture (26) of the support panel.

8. The assembly according to claim 7, wherein the locking device (120) further comprises at least one connecting tab (176), such that in the assembled configuration, said tab forms an electrical contact between the support panel (14) and the first mounting member (62).

9. The assembly according to any of claims 1 to 4, wherein the locking device (320) comprises: a flexible tongue (380), one end of which is attached to the flange (50) of the connector (16); and a pin (384) projecting from said tongue; such that in the assembled configuration the pin forms an abutment with the edge (39) of the insertion portion (32) of the aperture (26).

10. The assembly according to any one of the preceding claims, wherein the support panel comprises a plurality of mounting apertures (26), said assembly further comprising: a plurality of connectors (16), each connector being adapted to be assembled to one of said support panel apertures (26) in the assembled configuration; and a plurality of locking devices (20, 120, 220, 320), each of said devices being associated with one of said connectors.

11. A connector panel (12), made from an assembly (10) according to any of the preceding claims, said connector panel comprising the support panel (14), the connector (16), and the locking device (20, 120, 220, 320), wherein: the connector (16) is mounted on the support panel (14) in the assembled configuration; and the locking device blocks movement of the first mounting member (62) from the blocking portion (34) to the insertion portion (32) of the aperture (26).

12. A method of mounting the assembly (10) according to any of claims 1 to 10, comprising the following steps:
- bringing the flange (50) of the connector (16) into contact with the first face (22) of the support panel (14); and inserting the first mounting member (62) into the insertion portion (32) of the aperture (26); so as to resiliently deform the locking device (20, 120, 220, 320) from a rest position; and then
- moving the connector (16) relative to the support panel so that the first mounting member (62) is inserted into the blocking portion of the aperture, thereby returning the locking device to the rest position.
